# EUROPEAN PATENT APPLICATION

(11) **EP 4 625 487 A1**
(43) Date of publication of application: **01.10.2025**
(21) Application number: 23894505.9
(22) Date of filing: 16.11.2023
(51) Int. Cl.: H01L 23/373, C08K 3/22, C08K 3/28, C08L 83/04, C09K 5/14

(54) **SHEET-LIKE HEAT DISSIPATION MEMBER AND THERMALLY CONDUCTIVE COMPOSITE**

(30) Priority: 22.11.2022 JP 2022186289
(71) Applicant: SHIN-ETSU CHEMICAL CO., LTD., Tokyo 1000005 (JP)
(72) Inventor: ITO, Takanori, Annaka-shi, Gunma 379-0224 (JP)
(74) Representative: Angerhausen, Christoph
(86) International application number: PCT/JP2023/041218
(87) International publication number: WO 2024/111496

(57) **Abstract**

Provided is a heat dissipation member that exhibits good adhesion to heat-generating electronic components and heat dissipation components, has good thermal conductivity and insulating properties, and is superior in reliability. A sheet-like heat dissipation member includes a composition layer formed of a thermosoftening thermally conductive composition containing: (A) 100 parts by mass of a silicone resin being solid at 25°C and having one or more types of siloxane units selected from R¹SiO_{3/2} units, where R¹ is a monovalent hydrocarbon group having 1 to 10 carbon atoms, and the SiO_{4/2} unit; and (B) 1,200 to 3,500 parts by mass of a thermally conductive filler composed of (B-1) and (B-2) defined as: (B-1) 120 to 1750 parts by mass of alumina having an average particle diameter of 0.1 to 70 µm; and (B-2) 600 to 2880 parts by mass of aluminum nitride having an average particle diameter of 0.1 to 70 µm and a specific surface area of 4.0 m²/g or less, wherein the mass ratio (B-1)/(B-2) = 1/9 to 1/1.

## Description

### Technical Field

The present invention relates to a sheet-like heat dissipation member and a thermally conductive composite.

### Background Art

In recent years, thermosoftening materials, which are in an easy-to-handle solid state at room temperature and soften or melt in response to heat generated by electronic components, have been attracting attention as a measure to limit increases in the temperature of electronic components, for example in electronic devices. The thermosoftening materials are thermally conductive members having both of the following two properties: the ease of handling of a lowhardness thermally conductive sheet and the low thermal resistance of thermally conductive grease.

Silicone is known as a material superior in heat resistance, weatherability, and flame retardancy, which are required particularly for heat dissipation materials, and numerous silicone-based thermosoftening materials have been proposed.

In patent document 1, a composition composed of a thermoplastic silicone resin, a wax-like modified silicone resin, and a thermally conductive filler is proposed. In patent document 2, a thermally conductive sheet formed from a binder resin, such as silicone gel, a wax, and a thermally conductive filler is proposed. In patent document 3, a thermosoftening heat dissipation sheet formed from a polymer gel, such as silicone, a compound that becomes liquid when heated, such as modified silicone or wax, and a thermally conductive filler is proposed.

These materials, however, have the drawback of being inferior in flame retardancy and heat resistance compared to silicone alone, because wax or similar organic substances or a wax obtained by modifying silicone is used in addition to silicone.

In applications in recent years demanding high levels of heat dissipation, furthermore, these materials have failed to achieve sufficient effectiveness due to poor thermal conductivity.

To address this, patent document 4 discloses a thermosoftening heat dissipation material that does not contain wax or similar organic substances or a wax obtained by modifying silicone, that contains a silicone resin as a matrix, and that has a specified particle diameter of a thermally conductive filler. The thermally conductive filler, however, is an electrically conductive copper powder, which has prevented the use of the material in insulating applications. The readily oxidizable nature of copper, furthermore, has posed a problem in terms of stable manufacturing control.

Incidentally, examples of ceramic thermally conductive fillers with which insulation can be ensured include aluminum nitride, boron nitride, alumina, magnesia, and silicon nitride.

To render a heat dissipation material highly thermally conductive, how densely the thermally conductive filler is packed is crucial. The filler itself also needs to be a material having as high a thermal conductivity as possible.

In this regard, aluminum nitride has a high intrinsic thermal conductivity of 170 W/mK, making it promising for achieving high thermal conductivity.

Aluminum nitride, however, has poor packability in silicone; densely packing it reduces the flowability of the silicone binder when thermally softened. This prevents the heat dissipation material from conforming to microscopic irregularities in the surface of the electronic component and the heat sink, resulting in high thermal contact resistance. Aluminum nitride, therefore, has posed the problem of reduced effective thermal conductivity.

Aluminum nitride, furthermore, has a problem with water resistance. In high-humidity environments, its own hydrolysis reaction and the cracking of silicone are accelerated, which has raised a concern that voids formed within the system reduce thermal conductivity.

By contrast, alumina exhibits relatively good compatibility with silicone; even when it is densely packed, the flowability of the silicone binder is likely to be maintained, and contact resistance is likely to be low. Alumina, however, has poor thermal conductivity, as its intrinsic thermal conductivity is 20 W/mK. Even when alumina is blended into thermosoftening materials as described above, therefore, it has been difficult to render the resulting heat dissipation material highly thermally conductive.

Accordingly, there has been a need to develop a heat dissipation material that can be rendered highly thermally conductive by densely packing a filler, that combines good handling and insulating properties, and that is also superior in reliability under high-temperature and high-humidity conditions.

### PRIOR ART DOCUMENTS

### Patent documents

Patent document 1: JP-A-2000-327917
Patent document 2: JP-A-2001-291807
Patent document 3: JP-A-2002-234952
Patent document 4: JP-A-2007-059877

### Summary of Invention

### Technical Problem

An object of the present invention, therefore, is to provide a heat dissipation member that exhibits good adhesion to heat-generating electronic components and heat dissipation components, has good thermal conductivity and insulating properties, and is superior in reliability.

### Solution to Problem

After extensive research to solve the above problems, the inventor found that the sheet-like heat dissipation member and thermally conductive composite specified below can achieve the above object, completing the present invention.

That is, the present invention is one that provides the sheet-like heat dissipation member and thermally conductive composite specified below.
<1> A sheet-like heat dissipation member including a composition layer formed of a thermosoftening thermally conductive composition containing:
   (A) 100 parts by mass of a silicone resin being solid at 25°C and containing, in an amount of 20 mol% or more, one or more types of siloxane units selected from R¹SiO_{3/2} units, wherein R¹ is a monovalent hydrocarbon group having 1 to 10 carbon atoms, and a SiO_{4/2} unit; and
   (B) 1,200 to 3,500 parts by mass of a thermally conductive filler composed of (B-1) and (B-2) defined as:
      (B-1) 120 to 1750 parts by mass of alumina having an average particle diameter of 0.1 to 70 µm; and
      (B-2) 600 to 2880 parts by mass of aluminum nitride having an average particle diameter of 0.1 to 70 µm and a specific surface area of 4.0 m²/g or less,
   wherein a blending ratio between the (B-1) and the (B-2) is (B-1)/(B-2) = 1/9 to 1/1 as a mass ratio.
<2> The sheet-like heat dissipation member according to <1>, wherein the component (A) further contains an R¹₂SiO_{2/2} unit, wherein R¹ is a monovalent hydrocarbon group having 1 to 10 carbon atoms.
<3> The sheet-like heat dissipation member according to <1> or <2>, wherein the thermosoftening thermally conductive composition further contains:
   (D) 1 to 30 parts by mass, per 100 parts by mass of the component (A), of a linear-chain organopolysiloxane having a viscosity at 25°C of 0.1 to 100 Pa·s and containing, per molecule, one or more aryl groups having 6 to 12 carbons.
<4> The sheet-like heat dissipation member according to any one of <1> to <3>, wherein the component (B-1) is spherical alumina.
<5> The sheet-like heat dissipation member according to any one of <1> to <4>, wherein the thermosoftening thermally conductive composition further contains:
   (C) 1 to 20 parts by mass, per 100 parts by mass of the component (A), of an alkylalkoxysilane represented by general formula (1) defined as:

   R²ₐR³_{b}Si(OR⁴)_{4-a-b} (1),

   wherein, in formula (1), R² is an alkyl group having 6 to 15 carbon atoms, R³ is a monovalent hydrocarbon group having 1 to 4 carbon atoms, R⁴ is an alkyl group having 1 to 6 carbon atoms, a is an integer of 1 to 3, and b is an integer of 0 to 2, with the proviso that a + b is an integer of 1 to 3.
<6> The sheet-like heat dissipation member according to any one of <1> to <5>, wherein a thermal conductivity of a cured form of the thermosoftening thermally conductive composition is 4.0 W/mK or more.
<7> The sheet-like heat dissipation member according to any one of <1> to <6>, wherein a thickness of the composition layer is from 50 to 300 µm.
<8> The sheet-like heat dissipation member according to any one of <1> to <7>, wherein a breakdown voltage of the member as measured using a method specified in JIS K6249: 2003 is 1 kV or more.
<9> A thermally conductive composite including a reinforcing layer (X) made of a thermoplastic resin and the sheet-like heat dissipation member according to any one of <1> to <8> disposed on both sides of the reinforcing layer.
<10> The thermally conductive composite according to <9>, wherein the thermoplastic resin is any of an aromatic polyimide resin, a polyamide resin, a polyamideimide resin, a polyester resin, or a fluorocarbon resin.
<11> The thermally conductive composite according to <9> or <10>, wherein a thickness of the reinforcing layer (X) is from 2 to 20 µm.

It should be noted that as used herein, "room temperature" refers to a range of 15°C to 30°C, and "non-flowable" refers to a state in which the substance does not readily flow, specifically a state such that when a 50-g sample of the substance is placed in a 100-ml volume glass vial, the vial is laid horizontally, tilted at 45° from that position, and maintained for 1 hour, the sample does not deform.

### Advantageous Effects of Invention

The sheet-like heat dissipation member according to the present invention is one that includes a composition layer formed of a thermosoftening thermally conductive composition in which a silicone resin that is solid at 25°C and particular types of aluminum nitride and alumina as thermally conductive fillers are combined, and in which their blending proportions and loadings have been optimized. By virtue of this, the sheet-like heat dissipation member according to the present invention exhibits good thermal conductivity and insulating properties and achieves good adhesion to heat-generating electronic components and heat dissipation components, helping accomplish highly efficient heat dissipation. Superior in reliability as well, furthermore, the sheet-like heat dissipation member can also be applied to on-board automotive applications, in which high durability is required.

The sheet-like heat dissipation member according to the present invention can be used for, for example, heat dissipation from equipment such as general power supplies and electronic devices, heat dissipation from integrated circuit elements, such as LSI chips and CPUs, used in electronic devices such as personal computers and digital video disk drives, and heat dissipation from IGBT modules, DCDC converters, LED fog lamps, and other equipment in on-board automotive applications.

### Description of Embodiments

The present invention will now be described in detail.

### [Component (A)]

Component (A) is a silicone resin and is a component that forms the matrix of the sheet-like heat dissipation member according to the present invention. Component (A), furthermore, is a contributing factor for the sheet-like heat dissipation member according to the present invention to undergo thermal softening, and is a component that also plays a role as a binder that imparts workability and operability to the thermally conductive filler as component (B).

Component (A) is characterized in that it is a silicone resin that is solid at 25°C and contains, in an amount of 20 mol% or more, one or more types of siloxane units selected from R¹SiO_{3/2} units (Where R¹ is a monovalent hydrocarbon having 1 to 10 carbon atoms.) and the SiO_{4/2} unit.

In this context, R¹ is a monovalent hydrocarbon group having 1 to 10 carbon atoms, preferably a monovalent hydrocarbon group having 1 to 6 carbon atoms. Specific examples of R¹ include alkyl groups, such as a methyl group, an ethyl group, a propyl group, an isopropyl group, a butyl group, an isobutyl group, a tert-butyl group, a pentyl group, a neopentyl group, a hexyl group, a cyclohexyl group, an octyl group, a nonyl group, and a decyl group; aryl groups, such as a phenyl group, a tolyl group, a xylyl group, and a naphthyl group; aralkyl groups, such as a benzyl group, a phenylethyl group, and a phenylpropyl group; and alkenyl groups, such as a vinyl group, an allyl group, a propenyl group, an isopropenyl group, a butenyl group, a hexenyl group, a cyclohexenyl group, and an octenyl group. It should be noted that R¹ may be one of such hydrocarbon groups in which a subset or all of the hydrogen atoms present in it have been replaced with a halogen atom, such as a fluorine atom. Of these, a methyl group, a phenyl group, and a vinyl group are particularly preferred.

Examples of silicone resins as component (A), which are solid at 25°C and contain one or more types of siloxane units selected from R¹SiO_{3/2} units (hereinafter also referred to as T units) and the SiO_{4/2} unit (hereinafter also referred to as the Q unit), include silicone resins composed of an M unit (R¹₃SiO_{1/2} unit) and a T unit; silicone resins composed of an M unit and the Q unit; and silicone resins composed of an M unit, a T unit, and the Q unit.

In all siloxane units in component (A), the total percentage of T units and the Q unit is 20 mol% or more, preferably from 20 to 98 mol%, more preferably from 30 to 96 mol%.

In particular, silicone resins containing a T unit are preferred because they help increase toughness. Through this, damage during handling, for example, can be prevented by improving brittleness when the heat dissipation member is solid at room temperature.

For the improvement of toughness at room temperature, furthermore, component (A) may contain a D unit (R¹₂SiO_{2/2} unit) as its constituent unit. Examples of silicone resins that also contain a D unit include silicone resins composed of a T unit and a D unit; silicone resins composed of an M unit, a T unit, and a D unit; and silicone resins composed of an M unit, the Q unit, and a D unit. In this case, the substituent (R¹) in the T unit is preferably a methyl group or a phenyl group, and the substituent in the D unit is preferably a methyl group, a phenyl group, or a vinyl group. For silicone resins composed of an M unit, a T unit, and a D unit, moreover, the proportions (molar ratio) between the T unit and the D unit are preferably T:D = 10:90 to 90: 10, more preferably 20:80 to 80:20 in particular.

More specific examples of component (A) include the following silicone resins.

DₘTΦₚD^{Vi}ₙ

(In this formula, D represents a dimethylsiloxane unit (i.e., (CH₃)₂SiO_{2/2}), TΦ represents a phenylsiloxane unit (i.e., (C₆H₅)SiO_{3/2}), and D^{Vi} represents a methylvinylsiloxane unit (i.e., (CH₃)(CH₂=CH)SiO_{2/2}), (m + n)/p (molar ratio) = 0.25 to 4.0, and (m + n)/m (molar ratio) = 1.0 to 4.0.)

M_{L}TΦₚ

(In this formula, M represents a trimethylsiloxane unit (i.e., (CH₃)₃SiO_{1/2}), and TΦ represents a phenylsiloxane unit (i.e., (C₆H₅)SiO_{3/2}), and L/p (molar ratio) = 0.02 to 3.0.)

M_{L}DₘTΦₚD^{Vi}ₙ

(In this formula, M represents a trimethylsiloxane unit (i.e., (CH₃)₃SiO_{1/2}), D, TΦ, and D^{Vi} are as defined above, (m + n)/p (molar ratio) = 0.25 to 4.0, (m + n)/m (molar ratio) = 1.0 to 4.0, and L/(m + n) (molar ratio) = 0.001 to 0.1)

M_{L}DₘQ_{q}D^{Vi}ₙ

(In this formula, Q represents SiO_{4/2}, M, D, and D^{Vi} are as defined above, (m + n)/q (molar ratio) = 0.25 to 4.0, (m + n)/m (molar ratio) = 1.0 to 4.0, and L/(m + n) (molar ratio) = 0.001 to 0.1)

As long as component (A) is in such a structure, the sheet-like heat dissipation member according to the present invention is substantially solid at 25°C, and is fluidizable through thermal softening, reduction in viscosity, or melting at temperatures equal to or higher than a certain temperature, preferably 40°C or above, and equal to or lower than the maximum temperature reached due to heat generated by the heat-generating electronic component, specifically within a temperature range of approximately 40°C to 150°C, approximately 40°C to 120°C in particular.

In this context, the temperatures at which thermal softening, reduction in viscosity, or melting occurs are based on the temperature of the heat dissipation member; the silicone resin as component (A) itself may be one having a melting point below 40°C.

One component (A) may be used alone, or two or more may be used in combination.

As stated above, the silicone resin as component (A) only needs to exhibit a certain degree of reduction in viscosity upon heating, and only needs to be capable of serving as a binder for the thermally conductive filler. The weight-average molecular weight of component (A) is preferably from 500 to 20,000, particularly preferably from 1,000 to 10,000, as a polystyrene-equivalent molecular weight in GPC analysis. When the molecular weight falls within these ranges, the viscosity of the resulting composition after thermal softening can be more easily maintained within a suitable range. Pump-out caused by thermal cycling (the formation of air bubbles or the expulsion of the silicone resin due to separation between the filler and the silicone resin), therefore, can be more easily prevented, and adhesion between the resulting heat dissipation member and the electronic component or heat dissipation component can be more easily maintained. It should be noted that component (A) is preferably one that imparts flexibility or tackiness to the heat dissipation member according to the present invention. Component (A) may be a polymer with a single molecular weight, but may alternatively be a mixture of two or more polymers, for example, with different molecular weights.

### [Component (B)]

The thermally conductive filler as component (B) is characterized in that it contains, in a particular blending ratio, alumina, which is component (B-1), and aluminum nitride having a specific surface area of 4.0 m²/g or less, which is component (B-2), each having a particular average particle diameter.

The average particle diameter of the alumina as component (B-1) is from 0.1 to 70 µm, preferably from 0.5 to 60 µm, more preferably from 1.0 to 50 µm. When the average particle diameter falls within these ranges, component (B) can be more easily brought into a closest-packed state when it is densely packed. This is advantageous for attaining high thermal conductivity and also makes the shaped article superior in handling.

It should be noted that in the present invention, the average particle diameters are volume-average particle diameters and values measured using MT3300EX Microtrac particle size analyzer (Nikkiso Co., Ltd.).

Examples of shapes of the alumina as component (B-1) include spherical, round, and crushed, and it is particularly preferred that the alumina be spherical. In this context, spherical refers to a form such that the aspect ratio of the particle shape is 1.5 or less.

The blended amount of the alumina as component (B-1) is from 120 to 1750 parts by mass, preferably from 300 to 1,600 parts by mass, more preferably from 400 to 1,500 parts by mass, per 100 parts by mass of component (A), with the proviso that it satisfies the ranges specified below with regard to the blending ratio to component (B-2) and the total blended amount of component (B).

The average particle diameter of the aluminum nitride as component (B-2) is from 0.1 to 70 µm, preferably from 0.5 to 60 µm, more preferably from 1.0 to 50 µm. When the average particle diameter falls within these ranges, component (B) can be more easily brought into a closest-packed state when it is densely packed. This is advantageous for attaining high thermal conductivity and also makes the shaped article superior in handling.

The specific surface area of the aluminum nitride as component (B-2) is 4.0 m²/g or less, preferably 3.5 m²/g or less, more preferably 3.2 m²/g or less. When the specific surface area of the aluminum nitride exceeds the upper limit, the composition is one having poor extensibility, and the shaped article (sheet form) formed from it also tends to have reduced thermal conductivity due to the effects of, for example, hydrolysis when left under high-temperature and high-humidity conditions for an extended period. It should be noted that in the present invention, the specific surface areas are values measured by gas adsorption and are measured using, for example, Shimadzu Corporation's automatic specific surface area analyzer.

Examples of shapes of the aluminum nitride as component (B-2) include spherical, crushed, and round.

The blended amount of the aluminum nitride as component (B-2) is from 600 to 2880 parts by mass, preferably from 800 to 2,600 parts by mass, more preferably from 1,000 to 2,400 parts by mass, per 100 parts by mass of component (A), with the proviso that it satisfies the ranges specified below with regard to the blending ratio to component (B-1) and the total blended amount of component (B).

The blended amount of component (B), or the total blended amount of component (B-1) and component (B-2), needs to be from 1,200 to 3,500 parts by mass, preferably is from 1,500 to 3,000 parts by mass, per 100 parts by mass of component (A). When this blended amount is less than 1,200 parts by mass, the resulting composition may be one lacking storage stability as well as having poor thermal conductivity. When the blended amount exceeds 3,500 parts by mass, the composition may lack extensibility, and the shaped article may be weak in terms of strength.

In addition, the blending ratio between (B-1) and (B-2) is (B-1)/(B-2) = 1/9 to 1/1, preferably (B-1)/(B-2) = 1.5/8.5 to 1/1, more preferably (B-1)/(B-2) = 1/4 to 1/1, as a mass ratio.

When the ratio (B-1)/(B-2) falls within these ranges, the thermal conductivity of the shaped article can be effectively improved without impairing the flexibility/conformability of the heat dissipation member, even when component (B) is densely packed.

It should be noted that component (B) may be subjected to various known surface treatments, provided that the advantages of the present invention, such as thermal conductivity, are not significantly impaired. Specific examples include treatment with a coupling agent, such as a silane or titanate agent, and plasma treatment.

In the present invention, the following components can optionally be used, in addition to the essential components described above.

### [Component (C)]

Component (C) is an alkylalkoxysilane represented by general formula (1) below:

R²ₐR³_{b}Si(OR⁴)_{4-a-b} (1)

(In formula (1), R² is an alkyl group having 6 to 15 carbon atoms, R³ is a monovalent hydrocarbon group having 1 to 4 carbon atoms, R⁴ is an alkyl group having 1 to 6 carbon atoms, **a is an integer** of 1 to 3, and b is an integer of 0 to 2, with the proviso that a + b is an integer of 1 to 3.).

Component (C) is a wetter component and can be blended into the thermosoftening thermally conductive composition as an optional component. By treating the surface of the above-described thermally conductive filler as component (B) with component (C), wetting between component (B) and component (A) can be improved. As a result, component (C) aids in densely packing the thermally conductive powder as component (B).

R² is an alkyl group having 6 to 15 carbon atoms, and specific examples include a hexyl group, an octyl group, a nonyl group, a decyl group, a dodecyl group, and a tetradecyl group. When the number of carbon atoms is smaller than 6, wetting with the thermally conductive filler (component (B)) is likely to be insufficient. When the number of carbon atoms is greater than 15, component (C) readily solidifies at normal room temperature, and thus its handling is likely to be inconvenient. The heat resistance and flame retardancy of the resulting composition, furthermore, are likely to decrease.

R³ is a monovalent hydrocarbon group having 1 to 4 carbon atoms. It may be a saturated monovalent hydrocarbon group or may be an unsaturated monovalent hydrocarbon group, and the hydrogen atoms in the hydrocarbon group may be replaced with other atomic groups, such as halogen atoms. Specific examples include alkyl groups, such as a methyl group, an ethyl group, a propyl group, and a butyl group; alkenyl groups, such as a vinyl group, an allyl group, and an isopropenyl group; and halogenated alkyl groups, such as a 3,3,3-trifluoropropyl group. A methyl group and an ethyl group are particularly preferred.

R⁴ is an alkyl group having 1 to 6 carbon atoms, and specific examples include a methyl group, an ethyl group, a propyl group, a butyl group, a pentyl group, and a hexyl group. A methyl group and an ethyl group are particularly preferred.

a is an integer of 1 to 3, but particularly preferably is 1. b is an integer of 0 to 2, with the proviso that a + b is an integer of 1 to 3.

Specific examples of component (C) include compounds such as the following alkylalkoxysilanes.
C₆H₁₃Si(OCH₃)₃
C₁₀H₂₁Si(OCH₃)₃
C₁₂H₂₅Si(OCH₃)₃
C₁₂H₂₅Si(OC₂H₅)₃
C₁₀H₂₁Si(CH₃)(OCH₃)₂
C₁₀H₂₁Si(C₆H₅)(OCH₃)₂
C₁₀H₂₁Si(CH₃)(OC₂H₅)₂
C₁₀H₂₁Si(CH=CH₂)(OCH₃)₂
C₁₀H₂₁Si(CH₂CH₂CF₃)(OCH₃)₂

The blended amount of component (C) is preferably from 1 to 20 parts by mass, more preferably from 2 to 15 parts by mass, per 100 parts by mass of the silicone resin as component (A). When the blended amount falls within these ranges, the blending of component (C) is effective. The thermally conductive filler can be efficiently packed, and the handling of the sheet is also good.

### [Component (D)]

The thermosoftening thermally conductive composition used in the sheet-like heat dissipation member according to the present invention preferably contains, as component (D), a linear-chain organopolysiloxane having a viscosity at 25°C of 0.1 to 100 Pa·s and containing, per molecule, one or more aryl groups having 6 to 12 carbons, in addition to components (A) to (C) described above.

As also stated in the above description of component (A), it is known that introducing a D unit into (A) the silicone resin helps improve the toughness of the resin. In addition, the inventor found that even without introducing a D unit into (A) the silicone resin, blending a separate linear-chain organopolysiloxane containing a D unit also produces the same effect. When it is desired to impart toughness to the thermosoftening thermally conductive composition, therefore, it is preferred to blend, as component (D), a linear-chain organopolysiloxane containing, per molecule, one or more aryl groups having 6 to 12 carbons. Component (D) is preferably in an oil form or gum form, and when it is in an oil form, it is preferred that its viscosity be from 0.1 to 100 Pa·s. As long as the viscosity falls within this range, brittleness can be improved by increasing toughness.

The blended amount of component (D) is preferably from 1 to 30 parts by mass, more preferably from 2 to 15 parts by mass, per 100 parts by mass of component (A).

### [Other Additives]

To the thermosoftening thermally conductive composition used in the sheet-like heat dissipation member according to the present invention, materials such as additives or fillers typically used in synthetic rubber can be further added as optional components, provided that the object of the present invention is not defeated. Specifically, silicone oil and fluorine-modified silicone surfactants may be added as release agents; carbon black, titanium dioxide, red iron oxide, etc., may be added as coloring agents; platinum catalysts and metal oxides or metal hydroxides, such as iron oxide, titanium oxide, and cerium oxide, may be added as flame retardants; and process oils, reactive titanate catalysts, reactive aluminum catalysts, etc., may be added as workability improvers. **In** addition, materials such as fine-particle silica, e.g., precipitated silica or pyrogenic silica, or thixotropy improvers can optionally be added as agents for preventing the precipitation of the thermally conductive filler at high temperatures.

### [Manufacturing Method]

The thermosoftening thermally conductive composition used in the sheet-like heat dissipation member according to the present invention can be easily manufactured by blending and kneading the components described above using a rubber kneading machine, such as a dough mixer (kneader), a gate mixer, or a planetary mixer.

The sheet-like heat dissipation member according to the present invention includes a composition layer produced by shaping the thermosoftening thermally conductive composition into a sheet form. In this context, sheet form is used in a sense encompassing film form and tape form. Examples of methods for shaping the composition into a sheet form include the method of shaping the composition, after the kneading described above, by a technique such as extrusion molding, calendering, roll shaping, or press molding, and the method of coating with the composition dissolved in a solvent. It should be noted that the thickness of the composition layer of the sheet-like heat dissipation member manufactured in such a manner is preferably from 50 to 300 µm, more preferably from 50 to 250 µm, particularly preferably from 50 to 200 µm. When the thickness falls within these ranges, good handling and good heat dissipation performance are likely to be maintained.

The sheet-like heat dissipation member according to the present invention can further include a substrate having a surface treated with a release agent as a separator film (hereinafter also referred to as a releasable film). More specifically, a separator film may be placed on both sides of the composition layer of the sheet-like heat dissipation member such that the treated surface of the substrate is in contact with the composition layer. The inclusion of separator films in the sheet-like heat dissipation member helps facilitate handling, such as transportation and cutting to specified lengths. In this case, it is also possible to vary peel strength between the two separator films placed on the two sides by changing the amount and type of release agent and the materials for the films.

The separator films are preferably paper or PET films that have undergone release treatment with a non-dimethyl silicone polymer. Examples of non-dimethyl silicone polymers include nonreactive fluorosilicone release agents, in which a fluorinated group, such as a perfluoroalkyl group or a perfluoropolyether group, is bound to the backbone (hereinafter also referred to as fluorine-modified silicone separators). The perfluoropolyether group can be represented by formulae (2) to (4) below. 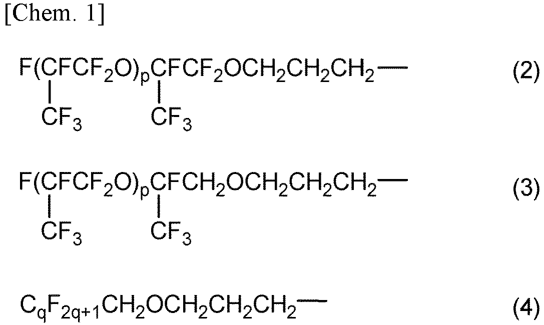 (p is a number from 1 to 5, and q is a number from 3 to 10)

Examples of commercially available nonreactive fluorosilicone release agents that can be used include products such as X-70-201, X-70-258, and X-41-3035, manufactured by Shin-Etsu Chemical Co., Ltd. Examples of methods for coating the substrate with the release agent include, but are not limited to, applying the material in liquid form onto the substrate using equipment such as a bar coater, a knife coater, a comma coater, or a spin coater and then curing the material by heating.

### [Thermal Conductivity and Viscosity]

The thermal conductivity of the composition layer of the sheet-like heat dissipation member according to the present invention, or of the cured form of the thermosoftening thermally conductive composition, is preferably 4.0 W/m·K or more, more preferably from 6.0 to 20.0 W/m·K. When the thermal conductivity falls within these ranges, high thermal conductivity is likely to be maintained between the electronic component and the heat dissipation component, such as a heat sink. Sufficient heat dissipation performance, therefore, is likely to be exhibited.

The thermal conductivity is a value calculated from the thermal resistance as measured by the laser flash method and the thickness of the cured composition.

The thermosoftening thermally conductive composition used in the sheet-like heat dissipation member according to the present invention, furthermore, preferably has a viscosity at 80°C in the range of 0.5 × 10² to 1 × 10⁵ Pa·s, more preferably in the range of 1.5 × 10² to 5 × 10⁴ Pa·s. When the viscosity falls within these ranges, the heat dissipation member is unlikely to flow out from between the electronic component and the heat dissipation component, such as a heat sink. The gap between the electronic component and the heat dissipation component, furthermore, can be more easily reduced, facilitating the exhibition of sufficient heat dissipation performance.

The viscosity at 80°C is a value measured using RDA3 rheometer (manufactured by TA Instruments, Inc.).

### [Method for Manufacturing a Thermally Conductive Composite]

The sheet-like heat dissipation member according to the present invention can be made into a thermally conductive composite with improved handling and insulating properties by stacking it with a reinforcing layer (X) of any type. The reinforcing layer is preferably a synthetic resin film layer, which is superior in heat resistance and electrical insulation while being flexible and exhibiting high mechanical strength. A suitable reinforcing layer can be selected from known substrates and used.

The synthetic resin film layer typically has a thickness of 2 to 20 µm. Preferably, the thickness falls within the range of 5 to 15 µm. When the synthetic resin film layer is too thick, a problem will occur with the thermal conductivity of the composite according to the present invention. Conversely, when the resin film layer is too thin, the layer may fail to achieve the strength that it should exhibit as a reinforcing layer, and its electrical insulation performance may be insufficient due to degraded withstand voltage characteristics. This synthetic resin film, furthermore, is preferably a film layer free of pores that would reduce withstand voltage characteristics.

Examples of synthetic resins include aromatic polyimide resins; polyamide resins; polyamideimide resins; polyester resins, such as polyethylene naphthalate; and fluorocarbon resins, such as polytetrafluoroethylene (PTFE) and tetrafluoroethylene-perfluoroalkyl vinyl ether copolymers. When a fluorocarbon resin is used as the synthetic resin, subjecting the surface of the film used to chemical etching treatment using a metallic sodium/naphthalenebased treatment solution is preferred from the viewpoint of improving adhesiveness.

The synthetic resin film is particularly preferably a heat-resistant film having a melting point of 200°C or above, preferably 250°C or above, so that reduction in mechanical strength does not occur due to thermal deformation. Examples of synthetic resin films having heat resistance with a melting point of 250°C or above include Kapton^{®} MT (trade name; manufactured by Du Pont-Toray Co., Ltd.), which is an aromatic polyimide film.

A method for manufacturing the thermally conductive composite according to the present invention is one in which a sheet-like heat dissipation member as described above is placed as an outer layer on both sides of a reinforcing layer (X) by pressure bonding at room temperature or thermocompression bonding. The method for placing the heat dissipation member is not particularly restricted; the placement can be performed as appropriate according to methods for manufacturing a composite known in the related art.

In the case of pressure bonding at room temperature, a sheet-like heat dissipation member formed in advance on a separator film as described above can be transferred to both sides of the reinforcing layer (X). In the case of thermocompression bonding, a pressing jig is heated to 40°C to 80°C, and transfer by pressure bonding is performed in the same manner. For the pressure bonding, pressure bonding using rollers, for example, may be used in addition to pressure bonding using a press. The composite, furthermore, may be manufactured by applying the composition for the heat dissipation member diluted in a solvent to both sides of the reinforcing layer (X) and drying the applied composition.

The sheet-like heat dissipation member or thermally conductive composite according to the present invention is placed between a heat-generating electronic component, which can reach a temperature higher than room temperature through operation, and a heat dissipation component. The heat dissipation member or composite is non-flowable at room temperature, and fluidizes in response to heat generated during the operation of the electronic component or to heat actively applied during the placement of the electronic component. The fluidized heat dissipation member or composite can fill the interface between the electronic component and the heat dissipation component, leaving substantially no voids.

### EXAMPLES

The present invention will now be described in further detail by presenting examples and comparative examples. The present invention, however, is not restricted to the examples described below.

The components (A) to (D) used in the Examples and Comparative Examples below are as follows.

### (A) Silicone Resin

(A-1) D₂₅TΦ₅₅D^{Vi}₂₀ (weight-average molecular weight, 3,300 as a polystyrene-equivalent value, solid at 25°C; softening point, 40°C to 50°C)
   In this formula, D represents a dimethylsiloxane unit (i.e., (CH₃)₂SiO_{2/2}), TΦ represents a phenylsiloxane unit (i.e., (C₆H₅)SiO_{3/2}), and D^{Vi} represents a methylvinylsiloxane unit (i.e., (CH₃)(CH₂=CH)SiO_{2/2}).
(A-2) M₂TΦ₅₀ (weight-average molecular weight, 3,100 as a polystyrene-equivalent value, solid at 25°C; softening point, 40°C to 50°C)
   In this formula, M represents a trimethylsiloxane unit (i.e., (CH₃)₃SiO_{1/2}), and TΦ represents a phenylsiloxane unit (i.e., (C₆H₅)SiO_{3/2})
(A-3) M₂D₂₀Q₄₀D^{Vi}₂₀ (weight-average molecular weight, 3,700 as a polystyrene-equivalent value, solid at 25°C; softening point, 40°C to 50°C)
   In this formula, M represents a trimethylsiloxane unit (i.e., (CH₃)₃SiO_{1/2}), D represents a dimethylsiloxane unit (i.e., (CH₃)₂SiO_{2/2}), Q represents SiO_{4/2}, and D^{Vi} represents a methylvinylsiloxane unit (i.e., (CH₃)(CH₂=CH)SiO_{2/2}).

### (B) Thermally Conductive Filler

(B-1-1) Spherical alumina having an average particle diameter of 2 µm
(B-1-2) Spherical alumina having an average particle diameter of 50 µm
(B-2-1) Crushed aluminum nitride having an average particle diameter of 2 µm (specific surface area, 3.2 m²/g)
(B-2-2) Crushed aluminum nitride having an average particle diameter of 30 µm (specific surface area, 2.0 m²/g)
(B-2-3) Crushed aluminum nitride having an average particle diameter of 0.5 µm (specific surface area, 5.6 m²/g; for comparative examples)

### (C) Alkylalkoxysilane (wetter component)

The alkylalkoxysilane represented by the following formula

C₁₀H₂₁Si(OCH₃)₃

### (D) Other Additives: Silicone Oil

A phenyl-containing linear-chain silicone oil having a viscosity at 25°C of 0.4 Pa·s (trade name, KF-54; manufactured by Shin-Etsu Chemical Co., Ltd.)

These components (A), (B), (C), and (D) were charged into a planetary mixer in the blended amounts specified in Table 1 or 2 below and mixed for 60 minutes to give a uniform composition.

### [Manufacturing of a Sheet]

To the composition obtained as described above, an appropriate amount of toluene was added. The resulting toluene solution was applied onto a fluorine-modified silicone separator (a PET substrate having a surface treated with X-41-3035 release agent (manufactured by Shin-Etsu Chemical Co., Ltd.); hereinafter referred to as a separator film) and heated to 80°C to evaporate the toluene, thereby forming a composition layer having a thickness of 200 µm on the separator film. By protecting this composition layer by placing another separator film on it such that the surface treated with a release agent was in contact with the layer, a sheet including a composition layer between two separator films was obtained. It should be noted that the thickness of 200 µm is the thickness of the composition layer alone; it does not include the thickness of the separator films.

### [Stacking with a Reinforcing Layer (manufacturing of a composite)]

**In** the same manner as in the manufacturing of a sheet described above, a toluene solution of the composition was applied onto a separator film and heated to 80°C to evaporate the toluene, thereby forming a composition layer having a thickness of 100 µm on the separator film. Two of these sheets were prepared in each example. The sheets were placed on both sides of an aromatic polyimide film (thickness: 5 µm), with one sheet on each side, such that the composition layer was in contact with the film, and the resulting stack was pressure-bonded at 70°C to yield a composite.

The thickness of the composition layer in the composite is as specified in Table 1. The size of the composite was 200 × 300 mm.

### [Evaluation Methods]

(1) Handling: The ease of handling was evaluated based on whether the desired adhesion was achieved when the sheet or composite was attached to a heat dissipation member (an aluminum heat sink).

The separator film on one side was removed, the composition layer of the sheet or composite was attached to the aluminum heat sink, and then the separator film on the other side was removed. Evaluation was made based on whether or not the attached sheet or composite was fixed in place without shifting off the heat sink or breaking.

A sheet or composite that was fixed without shifting or breakage was reported as ∘ in the table, and one that experienced shifting or breakage was reported as ×.

(2) Thermal Conductivity: After the removal of the separator films on both sides, the sheet or composite was sandwiched between aluminum plates, pressure-bonded at 50 psi, and then cured by heating in a drying oven under conditions of 150°C/1 hr. For the resulting cured composition, thermal resistance was measured by the laser flash method. Based on the relationship between the thickness of the cured composition and the thermal resistance, thermal conductivity was calculated.

(3) Reliability (thermal conductivity after high-temperature and high-humidity stress): The test sample subjected to the above thermal conductivity measurement was aged for 500 hours under high-temperature and high-humidity conditions of 85°C/85% Rh. Then thermal resistance measurement was performed again by the laser flash method, and thermal conductivity was calculated.

(4) Breakdown Voltage: Based on the method specified in JIS K6249: 2003, the breakdown voltage of the sheet or composite after the removal of the separator films on both sides was measured.

The results of these evaluations are presented in Tables 1 and 2.

**[Table 1]**

| Example | 1 | 2 | 3 | 4 | 5 | 6 | 7 | 8 | 9 | 10 | 11 | 12 |
|---|---|---|---|---|---|---|---|---|---|---|---|---|
| A-1 | 100 | 100 | 100 | 100 | 100 | 100 | 100 | 100 | | | | 100 |
| A-2 | | | | | | | | | 100 | 100 | | |
| A-3 | | | | | | | | | | | 100 | |
| B-1-1 | 200 | 250 | 150 | 500 | 700 | 200 | 200 | 200 | 200 | 330 | 200 | 180 |
| B-1-2 | 200 | 250 | 150 | 500 | 550 | 200 | 200 | 200 | 200 | 300 | 200 | 180 |
| B-2-1 | 400 | 400 | 400 | 200 | 450 | 400 | 400 | 400 | 200 | 100 | 400 | 500 |
| B-2-2 | 1200 | 1600 | 800 | 800 | 800 | 1200 | 1200 | 1200 | 1000 | 530 | 1200 | 580 |
| C | 10 | 12 | 10 | 10 | 12 | 15 | 5 | 10 | 8 | 5 | 12 | |
| D | 7 | 7 | 7 | 7 | 7 | 7 | 7 | 7 | 15 | 15 | 10 | |
| Reinforcing layer | None | None | None | None | None | None | None | Polyimide | None | None | None | None |
| Total of component B | 2000 | 2500 | 1500 | 2000 | 2500 | 2000 | 2000 | 2000 | 1600 | 1260 | 2000 | 1440 |
| (B-1)/(B-2) | 1/4 | 1/4 | 1/4 | 1/1 | 1/1 | 1/4 | 1/4 | 1/4 | 1/3 | 1/1 | 1/1 | 1/3 |
| Thickness of the composition layer (µm) | 200 | 200 | 200 | 200 | 200 | 200 | 200 | 200 | 200 | 200 | 200 | 200 |
| (1) Handling | ○ | ○ | ○ | ○ | ○ | ○ | ○ | ○ | ○ | ○ | ○ | ○ |
| (2) Thermal conductivity (W/mK) | 9.8 | 11.5 | 7.1 | 6.9 | 8.7 | 9.4 | 10.2 | 7.5 | 7.5 | 4.8 | 9.1 | 5.9 |
| (3) Thermal conductivity after high-temperature and high-humidity stress (W/mK) | 9.9 | 11.3 | 6.8 | 7.1 | 8.8 | 9.2 | 10.5 | 7.7 | 7.6 | 4.6 | 9.2 | 6.1 |
| (4) Breakdown voltage (kV) | 3.4 | 3.1 | 3.9 | 4.2 | 3.8 | 3.3 | 3.5 | 5.9 | 3.7 | 2.9 | 3.1 | 3.3 |

**[Table 2]**

| Comparative Example | 1 | 2 | 3 | 4 | 5 |
|---|---|---|---|---|---|
| A-1 | 100 | 100 | 100 | 100 | 100 |
| B-1-1 | 90 | 400 | 1000 | | 220 |
| B-1-2 | 90 | 400 | 500 | | 220 |
| B-2-1 | 360 | 1200 | 250 | 800 | |
| B-2-2 | 360 | 2000 | 250 | 1400 | |
| B-2-3 | | | | | 1760 |
| C | 8 | 13 | 10 | 10 | 13 |
| D | 7 | 7 | 7 | 7 | 7 |
| Reinforcing layer | None | None | None | None | None |
| Total of component B | 900 | 4000 | 2000 | 2200 | 2200 |
| (B-1)/(B-2) | 1/4 | 1/4 | 3/1 | 0/1 | 1/4 |
| Thickness of the composition layer (µm) | 200 | 200 | 200 | 200 | 200 |
| (1) Handling | ○ | × | ○ | ○ | ○ |
| (2) Thermal conductivity (W/mK) | 3.9 | ND | 4.8 | 8.0 | 7.5 |
| (3) Thermal conductivity after high-temperature and high-humidity stress (W/mK) | 4.5 | ND | 4.8 | 7.8 | 5.1 |
| (4) Breakdown voltage (kV) | 3.9 | ND | 3.6 | 3.2 | 2.7 |

In Examples 1 to 12, the heat dissipation member was superior in the ease of handling (adhesion to a heat dissipation component) of the shaped article (sheet or composite) and, at the same time, demonstrated good thermal conductivity and breakdown voltage as a heat dissipation member. The thermal conductivity after high-temperature and high-humidity stress, furthermore, was not significantly different from the initial thermal conductivity value either, indicating that the heat dissipation member was also superior in reliability.

In Comparative Example 1, by contrast, the shaped article (sheet) failed to achieve the desired thermal conductivity because the total amount of the thermally conductive filler as component (B) was as small as less than 1,200 parts by mass per 100 parts by mass of component (A).

In Comparative Example 2, the shaped article (sheet) was brittle and difficult to handle because the total amount of the thermally conductive filler as component (B) was as large as more than 3,500 parts by mass per 100 parts by mass of component (A). As a result, the evaluations other than handling were infeasible.

In Comparative Example 3, the thermal conductivity of the shaped article (sheet) decreased because the ratio of components (B-1)/(B-2) as component (B) exceeded the limit of 1/1.

In Comparative Example 4, thermal conductivity was not efficiently improved compared with Example 1 because the ratio of components (B-1)/(B-2) as component (B) fell below the limit of 1/9 and component (B-1) was not contained. As a result, the thermal conductivity of the shaped article (sheet) decreased.

In Comparative Example 5, a decrease in thermal conductivity was observed when the shaped article was aged for a prolonged period under high-temperature and high-humidity conditions, indicating reduced reliability, because aluminum nitride having a specific surface area exceeding 4.0 m²/g was used.

## Claims

1. A sheet-like heat dissipation member comprising a composition layer formed of a thermosoftening thermally conductive composition containing:
(A) 100 parts by mass of a silicone resin being solid at 25°C and containing, in an amount of 20 mol% or more, one or more types of siloxane units selected from R¹SiO_{3/2} units, wherein R¹ is a monovalent hydrocarbon group having 1 to 10 carbon atoms, and a SiO_{4/2} unit; and
(B) 1,200 to 3,500 parts by mass of a thermally conductive filler composed of (B-1) and (B-2) defined as:
(B-1) 120 to 1750 parts by mass of alumina having an average particle diameter of 0.1 to 70 µm; and
(B-2) 600 to 2880 parts by mass of aluminum nitride having an average particle diameter of 0.1 to 70 µm and a specific surface area of 4.0 m²/g or less,
wherein a blending ratio between the (B-1) and the (B-2) is (B-1)/(B-2) = 1/9 to 1/1 as a mass ratio.

2. The sheet-like heat dissipation member according to claim 1, wherein the component (A) further contains an R¹₂SiO_{2/2} unit, wherein R¹ is a monovalent hydrocarbon group having 1 to 10 carbon atoms.

3. The sheet-like heat dissipation member according to claim 1 or 2, wherein the thermosoftening thermally conductive composition further contains:
(D) 1 to 30 parts by mass, per 100 parts by mass of the component (A), of a linear-chain organopolysiloxane having a viscosity at 25°C of 0.1 to 100 Pa·s and containing, per molecule, one or more aryl groups having 6 to 12 carbons.

4. The sheet-like heat dissipation member according to claim 1, wherein the component (B-1) is spherical alumina.

5. The sheet-like heat dissipation member according to claim 1, wherein the thermosoftening thermally conductive composition further contains:
(C) 1 to 20 parts by mass, per 100 parts by mass of the component (A), of an alkylalkoxysilane represented by general formula (1) defined as:
R²ₐR³_{b}Si(OR⁴)_{4-a-b} (1),
wherein, in formula (1), R² is an alkyl group having 6 to 15 carbon atoms, R³ is a monovalent hydrocarbon group having 1 to 4 carbon atoms, R⁴ is an alkyl group having 1 to 6 carbon atoms, a is an integer of 1 to 3, and b is an integer of 0 to 2, with the proviso that a + b is an integer of 1 to 3.

6. The sheet-like heat dissipation member according to claim 1, wherein a thermal conductivity of a cured form of the thermosoftening thermally conductive composition is 4.0 W/mK or more.

7. The sheet-like heat dissipation member according to claim 1, wherein a thickness of the composition layer is from 50 to 300 µm.

8. The sheet-like heat dissipation member according to claim 1, wherein a breakdown voltage of the member as measured using a method specified in JIS K6249: 2003 is 1 kV or more.

9. A thermally conductive composite comprising a reinforcing layer (X) made of a thermoplastic resin and the sheet-like heat dissipation member according to claim 1 disposed on both sides of the reinforcing layer.

10. The thermally conductive composite according to claim 9, wherein the thermoplastic resin is any of an aromatic polyimide resin, a polyamide resin, a polyamideimide resin, a polyester resin, or a fluorocarbon resin.

11. The thermally conductive composite according to claim 9 or 10, wherein a thickness of the reinforcing layer (X) is from 2 to 20 µm.
